# EUROPEAN PATENT APPLICATION

(11) **EP 1 076 358 A2**
(43) Date of publication of application: **14.02.2001**
(21) Application number: 99124009.4
(22) Date of filing: 08.12.1999
(51) Int. Cl.: H01L 21/00

(54) **Processing apparatus and method for cleaning this processing apparatus**

(30) Priority: 11.08.1999 JP 22761899
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Satoh, Noritada, 2-chome Minato-ku, Tokyo 108-0075 (JP); Ohira, Kouichi, 2-chome Minato-ku, Tokyo 108-0075 (JP); Matsui, Bunya, 2-chome Minato-ku, Tokyo 108-0075 (JP); Maeda, Kazuo, 2-chome Minato-ku, Tokyo 108-0075 (JP)
(74) Representative: Schwabe - Sandmair - Marx

(57) **Abstract**

The present invention relates to an impurity processing apparatus in which impurities such as phosphorus, born, or the like are doped on a semiconductor substrate, etc., or a PSG (PhosphoSilicateGlass) film, a BSG (BoroSilicateGlass) film, or a BPSG (BoroPhosphoSilicateGlass) film, or a carbon film, etc. is formed. This structure is characterized in that a chamber (11) comprises an introduction port of an impurity containing gas which is connected to an impurity containing gas supply part (102B), a substrate holder (12b) supporting a to-be-processed layer which is ion-injected, or doped, or on which a film is formed using the impurity containing gas, an introduction port of a water containing gas which is provided in an upstream of the substrate holder (12b) in accordance with a flow direction of the impurity containing gas, and is connected to a water containing gas supply part 102C, and first plasma generating means (12a, 12b, 16) which are provided in a space from the introduction port of the water containing gas to the substrate holder (12b), and plasmanizes the water containing gas.

## Description

### BACKGROUND OF THE INVENTION

### 1. Field of the Invention

The present invention relates to an impurity processing apparatus in which impurities such as phosphorus, born, or the like are doped on a semiconductor substrate, etc., or a PSG (PhosphoSilicateGlass) film, a BSG (BoroSilicateGlass) film, or a BPSG (BoroPhosphoSilicateGlass) film, or a carbon film, etc. is formed and a method for cleaning the impurity processing apparatus.

### 2. Description of the Prior Art

In recent years, in manufacturing a semiconductor integrated circuit apparatus of superhigh integration, in the case where a p-type or n-type impurity region is formed in a semiconductor substrate, or in the case where an amorphous boron film or an amorphous carbon film is formed for using in neutron rays absorption, there are well-known an ion injecting method, a plasma doping method using a parallel plate type electrode, a wave guide for microwaves (u waves) causing an ECR (Electron Cyclotron Resonance), or a plasma generating means such as a power radiating antenna or the like for generating helicon-plasma, or a plasma CVD (Chemical Vapor Deposition) method using an impurity containing film forming gas which is made plasma (plasmanized) by such the plasma generating means, etc.

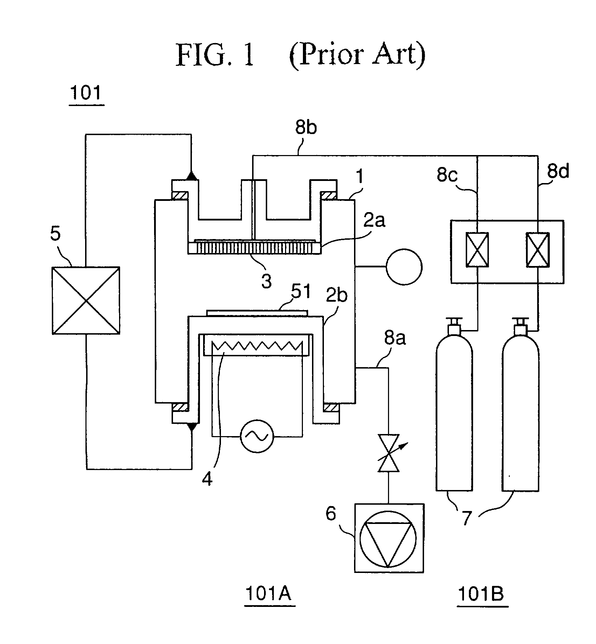

FIG. 1 is a side view showing a structure of a plasma doping apparatus 101 according to the prior art.

This plasma doping apparatus 101, as shown in FIG. 1, comprises a plasma process part 101A for doping an impurity on a substrate 51 by a plasma gas; and a doping gas supply part 101B having a doping gas source, and a parallel plate type electrode is used as a plasma generating source of the plasma process part 101A.

The plasma process part 101A, as shown in FIG. 1, plasmanize a doping gas and has a process chamber 1 which dopes for the substrate 51 by use thereof and can decompress.

The process chamber 1 is connected to an exhausting apparatus 6 through an inducting/exhausting piping 8a. A pair of upper electrode 2a and lower electrode 2b opposing to each other is provided in the process chamber 1, and a power is supplied from a power supply 5 of DC (a direct current), AC (an alternating current (frequency 50 Hz or 60 Hz)), LF (low frequency (frequency 100 to 800 kHz) or RF (radio frequency (frequency 1 to 25 MHz)) to between these electrodes 2a, 2b, and the doping gas is plasmanized. The upper electrode 2a, the lower electrode 2b and the power supply 5 constitute the plasma generating means for plasmanizing the doping gas.

The upper electrode 2a serves both as a dispersion member of the doping gas and is provided with a discharge port 3 of the doping gas. The discharge port 3 of the doping gas is connected to a doping gas supply part 101B via a piping 8b.

The lower electrode 2b serves also as a holding base of the substrate 51, and a heater 4 for heating the substrate 51 is provided under the lower electrode 2b.

A gas bomb 7 for accommodating the doping gas is installed in the doping gas supply part 101B. The doping gas is supplied from these gas bombs 7 to the process chamber 1 of the plasma process part 101A through pipings 8c, 8d, 8b.

In this plasma doping apparatus, if used repeatedly for a long period of time, an decomposed product of a gas containing an element to be doped adheres to an inner wall of a partition surface of the chamber 1 and surfaces of the electrodes 2a, 2b for generating a glow discharge, etc. Such circumstances are also same as even in an ion implantation system or a plasma CVD apparatus.

If the insulating decomposed product accumulates on the surfaces of the electrodes 2a, 2b for generating the glow discharge, a charge-up occurs to unstabilize the glow discharge. Furthermore, in an apparatus using the ECR, a glass surface of a window for introducing µ waves into a plasma generating chamber is contaminated, and the decomposed product accumulates even in the inner wall of the plasma generating chamber thereby to lower plasma generating efficiency.

If such state continues, the discharge is unstable and it becomes difficult to use it. Furthermore, in the worst case, the discharge stops and cannot be used.

Additionally, when a weak p type or n type is doped, the decomposed product containing doping impurities which adhere to the inner wall of the chamber is sputtered to adhere to a semiconductor substrate, and it becomes difficult to perform lower concentration doping. Then, in order to dope with excellent reproducibility, a removal of the decomposed product adhered to the inner wall of the chamber is necessary.

Normally, there are well-known the following methods for cleaning an interior of the chamber of such the processing apparatus:
(i) There is well-known a method for glow-discharging for at least an hour in a gas such as argon or hydrogen. Furthermore, as a method for cleaning an inner wall of an ion source housing of an ion implantation system, a method for using hydrogen or an alkyl based substance is disclosed in Japanese Application Laid-Open No. 3-64462, for example.
(ii) There is also known a method in which, after a devise is disassembled and each part is dipped in a mixture of, for example, a hydrogen peroxide solution and ammonia water, contaminants are manually shaved off by mechanical use of a sandpaper or a wire brush, and after cleaning the apparatus, it is reassembled and used.
(iii) As a method for cleaning a passing path of ion beams of the ion implantation system, a method for making gaseous a reaction product adhered to an inner wall, etc. by a glow discharge of an oxygen containing gas such as O₂, O₃ or the like, or a halogen fluoride gas such as CF₄, C₂F₆, NF₃ or the like and cleaning is disclosed in Japanese Application Laid-Open No. 4-112441, for example. Furthermore, an example using a halogen fluoride gas such as ClF₃ or the like is disclosed in Japanese Application Laid-Open No. 8-162433, for example.

However, there are the following drawbacks in a conventional method for cleaning an impurity processing apparatus: Namely,
(i) There are the following drawbacks in the method for glow-discharging in a gas such as argon or hydrogen. That is, in the case of argon, an impurity layer adhered to a surface of a silicon substrate is removed, but upon a removal of the surface of the silicon substrate, these impurity atoms invade into the silicon substrate due to knock-on effects to be active. Furthermore, an raw material of the inner wall of a reaction apparatus is sputtered to adhere to the surface of the silicon substrate and invade into the substrate, so that it may adversely affect apparatus characteristic.
   In the case of hydrogen, for example, when boron is an adhesive substance of a main component, a reaction product of boron and hydrogen generates, and when a reaction chamber is released to an outer air, as a diborane smell strongly drifts, it is unfavorable for a health of a human being. Moreover, if a glow discharge continues for about an hour, a roughness occurs on a surface of the silicon substrate. Furthermore, if the adhesive substance starts to be removed partially in argon or hydrogen, a discharge concentrates on the part and a roughness occurs on the inner wall of the apparatus, the electrode surface and the surface of the silicon substrate. In the other gases, as an adhesive substance is scarcely removed in helium, it is not practical.
(ii) In the method for disassembling a apparatus and cleaning it chemically with chemicals, or mechanically by a wire brush, etc., it takes much labor and time for a slight regulation or a recovery of a vacuum after assembled. Furthermore, a doping impurity element may adhere to a human body or be breathed in thereby, so that there are many inconvenient points for reasons of health.
(iii) In the method for making gaseous a reaction product adhered to the inner wall, etc. by the glow discharge of a halogen fluoride gas such as ClF₃, CF₄, C₂F₆ or the like and cleaning, the decomposed product of Cl or F generates and a sufficient caution in handling chemicals is necessary and a great amount of expenses for a public nuisance countermeasure for a rendering-harmless process of an exhaust gas, etc. are required. As the adhesive substance is scarcely removed in the other gases, for example oxygen, it is not practical.

### SUMMARY OF THE INVENTION

It is an object of the present invention to provide an impurity processing apparatus which has no problems in a reduction of operability of a apparatus or health for cleaning the apparatus, and can simply clean the apparatus; and a method for cleaning the impurity processing apparatus.

In the impurity processing apparatus of the present invention, a gas containing any one element simple substance selected from the group consisting of boron, phosphorus, arsenic, gallium, aluminum, germanium and carbon, or a gas containing a compound, etc. containing at least one element simple substance selected from the group consisting of the elements is used as an impurity containing gas. There are diborane (B₂H₆), boron trifluoride (BF₃), etc. as a compound containing boron (B), there are phosphine (PH₃), etc. as a compound containing phosphorus (P), there are arsine (AsH₃), etc. as a compound containing arsenic (As), there are trimethylgallium (TMG), etc. as a compound containing gallium (G), there are trimethylaluminum (TMA1), etc. as a compound containing aluminum (Al), there are germane (GeH₄), germanium tetrafluoride (GeF₄), etc. as a compound containing germanium (Ge), and there are methane (CH₄), etc. as a compound containing carbon (C). As the impurity containing gas used actually, a gas in which the simple substance or compound is diluted by hydrogen (H) or helium (He).

In the case where an ion injection, doping or a film formation is performed by using such the gases, for example, in the case of diborane, a by-product containing boron adheres to an inner wall of a chamber or a silicon surface.

In the prior art, hydrogen or a halogen fluoride gas has been used as a cleaning gas for removing this by-product. On the contrary, the present invention is characterized in that plasma of a water vapor (a evaporation gas of water) or a water containing carrier gas is used for removing the by-product. If plasma of water vapor, etc. is used, as compared with the case where hydrogen, etc. are used, the by-product is removed for a glow discharging period of time of about 1/10. Moreover, as a mirror surface of silicon is not caused a roughness, it still keeps in a mirror surface state.

In the case where the water vapor, etc. are used, the following things are considered as a reason why a removal rate is higher 10 times or more than the case where hydrogen, etc. are used.

When water is decompose, water is dissociated into H⁺ and OH- like ${\text{H}}_{\text{2}} {\text{O→ H}}^{\text{+}} {\text{+ OH}}^{\text{-}}$An impurity adhered after doping process reacts with these H⁺ and OH⁻ so that each is evaporated in the form of BH, PH, AsH, SbH, etc., and is removed from the inner wall of the chamber. Actually, when a plasma luminous spectrum in the glow discharge in the water vapor is observed, OH in addition to H is observed and simultaneously BH, PH, etc. are acknowledged. When such the examination results are considered, if OH generates, it is considered that it is promoted to form from a product containing impurities adhered to the inner wall, etc. of the process chamber after doping process to a hydride of the impurities.

### BRIEF DESCRIPTION OF THE DRAWING

FIG. 1 is a side view showing a structure of a conventional impurity processing apparatus;
FIG. 2 is a side view showing a structure of an impurity processing apparatus according to a first embodiment of the present invention;
FIG. 3 is a side view showing another structure of a water containing gas supply part of FIG. 2;
FIG. 4 is a cross-sectional view showing a method for forming a film by an impurity containing gas and then cleaning by using the impurity processing apparatus of FIG. 2;
FIG. 5 is a side view showing a structure of an impurity processing apparatus according to a second embodiment of the present invention;
FIG. 6 is a side view showing a structure of an ion implantation system according to a third embodiment of the present invention; and
FIG. 7 is a side view showing a structure of an impurity processing apparatus according to a fourth embodiment of the present invention.

### DESCRIPTION OF THE PREFERRED EMBODIMENT

Hereinafter, various embodiments of the present invention will be described with reference to the accompanying drawings.

### [First Embodiment]

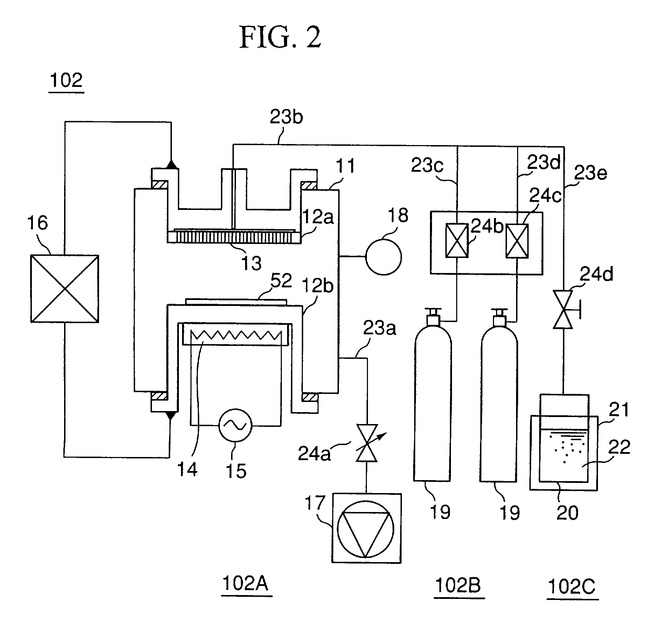

FIG. 2 is a side view showing a structure of a plasma doping apparatus (an impurity processing apparatus) 102 according to a first embodiment of the present invention.

This plasma doping apparatus 102 comprises a plasma process part 102A for doping an impurity on a substrate to be processed 52 by a plasma gas; a doping gas supply part (an impurity containing gas supply part) 102B having a doping gas (an impurity containing gas) source; and a water containing gas supply part 102C for generating a cleaning water containing gas, and a parallel plate type electrode is used as plasma generating means of the plasma process part 102A.

The plasma process part 102A, as shown in FIG. 2, plasmanize a doping gas and has a process chamber 11 which dopes for the substrate 52 by use thereof and can decompress.

The process chamber 11 is connected to an exhausting apparatus 17 through an inducting/exhausting piping 23a. There is provided a opening/shutting valve 24a for controlling communication/non-communication between the process chamber 11 and the exhausting apparatus 17 midway of the piping 23a. There is provided pressure measuring means 18 such as a vacuum gauge or the like for monitoring a pressure of an interior of the process chamber 11.

A pair of upper electrode 12a and lower electrode 12b opposing to each other is provided in the process chamber 11, and a power is supplied from a power supply 16 of DC (a direct current), AC (an alternating current (frequency 50 Hz or 60 Hz)), LF (low frequency (frequency 100 to 800 kHz) or RF (radio frequency (frequency 1 to 25 MHz)) to between these electrodes 12a, 12b, and the doping gas or the water containing gas) is plasmanized. The upper electrode 12a, the lower electrode 12b and the power supply 16 constitute second plasma generating means for plasmanizing the doping gas, and also constitute first plasma generating means for plasmanizing the water containing gas.

The upper electrode 12a serves both as a dispersion member of the impurity containing gas. A plurality of through holes are formed in the upper electrode 12a and an opening of the through hole on a face opposing to the lower electrode 12b is set as a discharge port (an introduction port) 13 of the doping gas or water containing gas. This discharge port 13 for the doping gas, etc. is connected to the doping gas supply part 102B and the water containing gas supply part 102C via the piping 23b.

The lower electrode 12b serves also as a holder (holder) of the substrate 52, and a heater 14 for heating the substrate 52 is provided under the lower electrode 12b. The heater 14 generates heat by supply of an electric power from the power supply 15.

A gas bomb 19 for accommodating the doping gas such as diborane (B₂H₆), phosphine (PH₃), etc. is installed in the doping gas supply part 102B. The doping gas is supplied from these gas bombs 19 to the process chamber 11 of the plasma process part 102A through pipings 23c, 23d, 23b. The two gas bombs 19 are connected thereto in FIG. 2, but can be more increased when another doping gas is necessary. There are installed gas controlling means 24b, 24c containing flow rate regulating means, opening/shutting means or the like midway of the pipings 23c, 23d extended from each gas bomb 19.

The water containing gas supply part 102C has a water containing gas making apparatus for making an water vapor. The apparatus comprises a water container 20 for accomodating water, a heater 21 for heating water 22, and a piping 23e for leading the water vapor. As described above, the piping 23e is linked to the process chamber 11. There are installed gas controlling means 24d, 24e containing flow rate regulating means, opening/shutting means or the like midway of each of the pipings 23e, 23f, respectively.

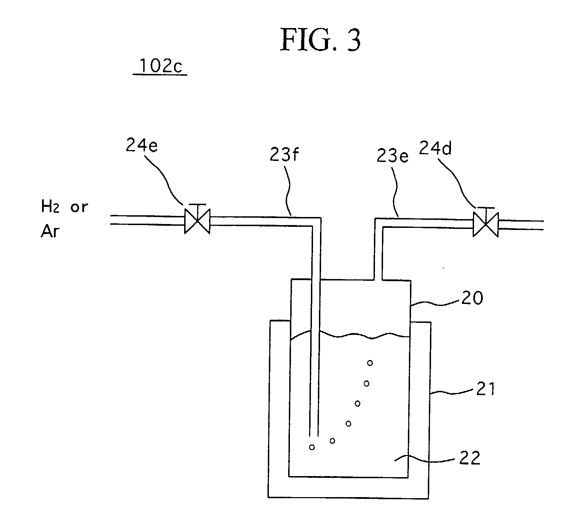

Incidentally, another structure is possible as a structure of the water containing gas supply part 102C. For example, FIG. 3 is a side view showing another structure of the water containing gas supply part 102C in FIG. 2. As shown in FIG. 3, a piping 23f for conducting a carrier gas is inserted into the water 22 in the water container 20, and the water can be included in the carrier gas. Hydrogen (H₂), argon (Ar), or the like can be used as the carrier gas. Further, the water vapor generated by heating water is mixed with a hydrogen gas (H₂) or an argon (Ar) gas, whereby this structure may be made so as to generate a water containing gas.

The plasma doping apparatus 102 described above comprises, in addition to a structure necessary for a normal plasma doping, a discharge port 13 of a water containing gas, provided in an upstream of a substrate holder 12b according to a flow direction of a doping gas; and first plasma generating means 12a, 12b, 16 for plasmanizing the water containing gas, provided in a space from the discharge port 13 of the water containing gas to the substrate holder 12b.

Incidentally, in the case of the first embodiment, the discharge port 13 of the water containing gas is provided in an upmost upstream of the first plasma generating means 12a, 12b, 16, and if the water containing gas is introduced therefrom, it can be plasmanized effectively. Furthermore, the substrate holder 12b is provided in a lowermost downstream of the first plasma generating means 12a, 12b, 16, and the plasma gas effectively reaches the substrate 52. Even such the case belongs to a scope of the present invention.

Accordingly, even if, after completion of the plasma doping, a by-product or a residue containing impurities exists in the chamber 11, it is possible to generate plasma of the water containing gas in a flow path of the doping gas. Hydrogen (H) or hydroxyl group (OH) in the plasma of the water containing gas forms an impurity and a hydride in an impurity containing gas. Furthermore, it is considered that the hydroxyl group (OH) promotes the reaction, and it is possible to remove the by-product or residue containing the impurity from the interior of the chamber 11 for a shorter period of time than in the prior art.

Then, a method for plasma-processing the substrate 52 by use of the above plasma doping apparatus 102 and continuously cleaning an interior of the plasma doping apparatus 102.

In order to set so that effects can experimentally and readily be confirmed, the experiment was carried out subject to steps shown in FIGS. 4A to 4C. In this case, the plasma doping apparatus 102 is used as a film forming apparatus. Then, the impurity containing gas containing boron or carbon is used as a film formation gas, thereby to form an amorphous boron film or amorphous carbon film 112.

First, as shown in FIG. 4A, the silicon substrate (a to-be-processed layer) 52 is mounted on the lower electrode 12b in the process chamber 11 shown in FIG. 2. Successively, the impurity containing gas is supplied into the process chamber 11, and a pressure in the process chamber 11 is held at about 1 Torr. In this case, when an amorphous boron film 111 is formed, a gas in which diborane (B₂H₆) is diluted to about 1000 ppm by hydrogen or helium is used as the impurity containing gas, or when the amorphous boron film 111 is formed, a gas in which methane (CH₄) is diluted to about 1000 ppm by hydrogen or helium is used.

Next, an electric power is supplied from a DC, AC, LF or RF power supply 16 to between the upper electrode 12a and the lower electrode 12b, and is applied on the impurity containing gas between the upper electrode 12a and the lower electrode 12b. Thus, the impurity containing gas is plasmanized and a surface of the silicon substrate 52 is exposed to this plasma. After a specified period of time, an amorphous boron film or amorphous carbon film 111 of a film thickness about 1 µm is formed on the silicon substrate 52. This is used as a cleaning sample.

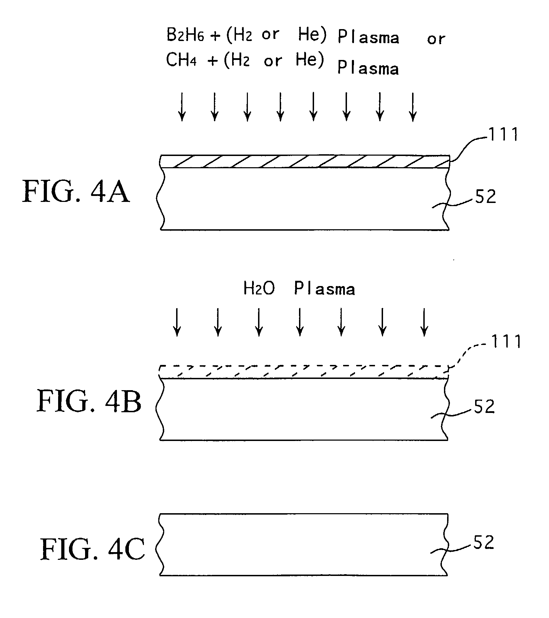

Next, as shown in FIG. 4B, after the impurity containing gas is stopped and a pressure in the process chamber 11 is set to about 10⁻³ Torr, an water vapor is introduced into the process chamber 11, and the pressure is held at 1 Torr. Continuously, an electric power is supplied from the DC, AC, LF or RF power supply 16, and is applied on the water vapor between the upper electrode 12a and the lower electrode 12b, thereby to cause a glow discharge. In the case of DC, a discharge voltage is set to about 500 V, or in the case of AC, the discharge voltage is set to 400 V, or in the case of LF and RF, an applied power is set to 100 to 1000 W. Thus, the water vapor in the process chamber 11 is plasmanized and the amorphous boron film or amorphous carbon film 111 is exposed to this plasma.

If this state is held for a specified period of time, as shown in FIG. 4C, the amorphous boron film or amorphous carbon film 111 is removed.

According to the experimental results, in the case of DC (a discharge voltage 590 V, a discharge current 0.27 A, (corresponding to substantially 160 W), AC (a discharge voltage 540 V, a discharge current 0.3 A, (corresponding to substantially 160 W), or LF and RF, the amorphous boron film or amorphous carbon film 111 of a film thickness 0.3 to 1 µm is approximately completely removed for about 10 to 20 min. Moreover, a surface of the silicon substrate 52 maintained a mirror surface state. A roughness on the surface as viewed in the case where hydrogen or argon was used as a cleaning gas was not observed.

From a viewpoint of the aforementioned experimental results, it is acknowledged that it is possible to remove by-products adhered to the inner wall of the process chamber 11 or the surface of the electrodes 12a, 12b by the plasma process of the water vapor. Actually, when making experiments under the same discharge conditions as above, it is possible to remove even the by-products of a film thickness several µm for a short period of time which is 1 to hours. It is, in particular, considered that this is due to a roughness and a porousness in the film quality of the by-product adhered to the inner wall, etc.

Incidentally, in the case where a phosphorus compound such as phosphine or the like is used as the impurity containing gas, an experiment by a film formation was not made as a thin film of phosphorus is not formed, but after processed by the plasma of phosphine or the like, the interior of the process chamber 11 is processed by the plasma of the water vapor under the same conditions as above. Then, even if the process chamber 11 is opened, an offensive odor of the phosphorus compound was not caused. Furthermore, a gas in the interior of the process chamber 11 was detected by PID (Photo Ionization Detector), but PH₃ was not detected.

As described above, according to the first embodiment of the present invention, after a plasma process of boron, carbon or phosphorus was performed, a plasma process of the water vapor or the water containing gas was performed, whereby it is possible to remove by-products generated in the process chamber 11 or residues containing phosphorus, etc. by the plasma process of boron, carbon or phosphorus from the interior of the process chamber 11 for a short period of time without damaging the inner wall, etc. of the apparatus.

Incidentally, in the above description, the compound of born, carbon and phosphorus is used as the impurity, but their simple substance may be used. Furthermore, diborane (B₂H₆) is used as the compound of boron, but the other compound, for example, boron trifluoride (BF₃) and other compounds can be also used. Methane (CH₄) is used as the compound of carbon, but the other compound can also be used. Phosphine (PH₄) is used as the compound of phosphorus, but the other compound can also be used.

Furthermore, the other impurity, for example, an arsenic, gallium, aluminum or germanium simple substance or the compound containing the simple substance can be used. Arsine (AsH₃) is typical as the compound of arsenic and trimethylgallium (TMG) is typical as the compound of gallium, and in the case of the compound of aluminum, trimethylaluminum (TMAl) is typical, and in the case of germanium, germane (GeH₄) or germanium tetrafluoride (GeF₄) is typical.

Furthermore, when a partition wall of the process chamber 11 is formed of aluminum, if the by-product is removed only by the water vapor as described above, as an alumina film is formed on the inner wall of the process chamber 11 or the surface of the electrode, an abnormal discharge due to charge-up is easy to occur. Then, the water vapor is mixed with hydrogen or an argon gas. In this case, it is preferable that hydrogen or the argon gas is added to the water vapor at a volumetric ratio about 50%. Alternatively, hydrogen or an argon gas is blown into water to be bubbled, and a glow discharge is caused under the above-described conditions by use of hydrogen or the argon gas containing water. As the alumina film is not formed by adding hydrogen or the argon gas thereto, a stable discharge can be attained.

### [Second Embodiment]

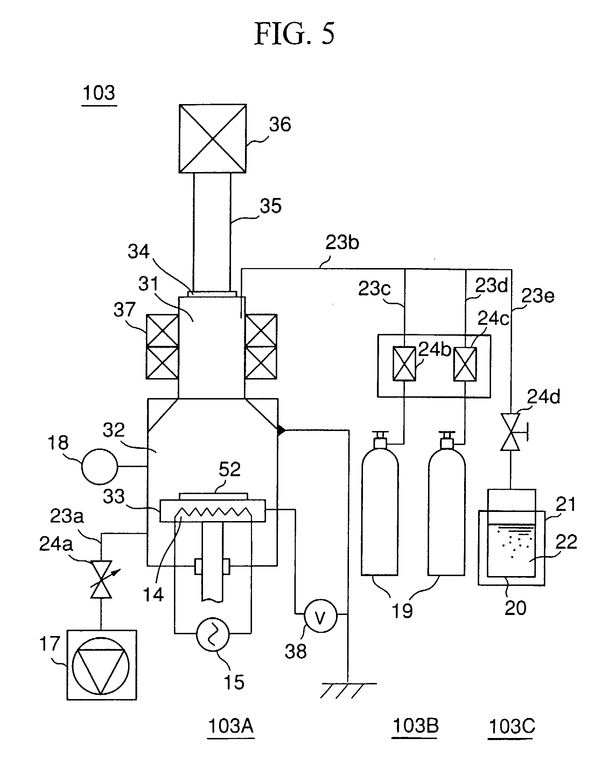

FIG. 5 is a side view showing a structure of a plasma doping apparatus (an impurity processing apparatus) 103 according to a second embodiment of the present invention. As a detailed structure of a water containing gas supply part 103C in FIG. 5 is same as in FIG. 2, the description is omitted.

FIG. 5 is a plasma doping apparatus (an impurity processing apparatus) having plasma generating means by an ECR (Electron Cyclotron Resonance), and FIG. 5 is different from FIG. 2 in that a plasma generation part 31 is separated from a plasma process part 32 and microwaves (frequency 2.45 GHz) are used as plasma generating means. Incidentally, even in this case, a plasma doping apparatus 103 can be used as a film forming apparatus.

Hereinafter, a apparatus structure according to the second embodiment will be described with reference to FIG. 5.

Similar to the apparatus structure of FIG. 2, the apparatus structure according to the second embodiment comprises a plasma process part 103A; an impurity containing gas supply part 103B; and a water containing gas supply part 103C. As the impurity containing gas supply part 103B and the water containing gas supply part 103C among them have the same structure as in FIG. 2, the description is omitted. Additionally, as like or similar reference numerals in FIG. 5 to those in FIG. 2 denote the same elements or parts as in FIG. 2, the description is omitted if unnecessary particularly.

The plasma process part 103A comprises the plasma generation part 31 and the plasma process part 32, and is partitioned from an external unit by a partition wall.

A piping 23b extended from the impurity containing gas supply part 103B and the water containing gas supply part 103C is connected to an upmost upstream part of the plasma generation part 31, with the result that an impurity containing gas or a water containing gas is introduced thereinto. Furthermore, the upmost upstream is connected to a wave guide 35 of microwaves via a glass plate 34, and a microwaves power of frequency 2.45 GHz is introduced from a power supply 36 to the plasma generation part 31. Furthermore, a coil 37 for generating a magnetic field is provided on an outer periphery of the partition wall of the plasma generation part 31, and an electron cyclotron resonance (ECR) is caused by the microwaves power and the magnetic field to add a power to the impurity containing gas or water containing gas to plasmanize.

The plasma process part 32 comprises a substrate holder 33, and a power source 38 is connected to between the partition wall enclosing the plasma process part 32 and the substrate holder 33, and a voltage can be applied to therebetween. This voltage biases the substrate holder 33 at a negative voltage, so that it is applied for accelerating ions.

As described above, the plasma doping apparatus 103 according to the second embodiment comprises not only a structure necessary for the standard plasma doping but also the water containing gas supply part 103C; further an introduction port of a water containing gas which is provided in an upstream of the substrate holder 33 in accordance with a flow direction of the impurity containing gas; and first plasma generating means 35, 36, 37 which are provided in a space from the introduction port of the water containing gas to the substrate holder 33 and plasmanize the water containing gas.

That is, the plasma generation part 31 is separated from the plasma process part 32, but since the second embodiment has the similar structure to the first embodiment, the second embodiment has similar effects to the first embodiment.

### [Third Embodiment]

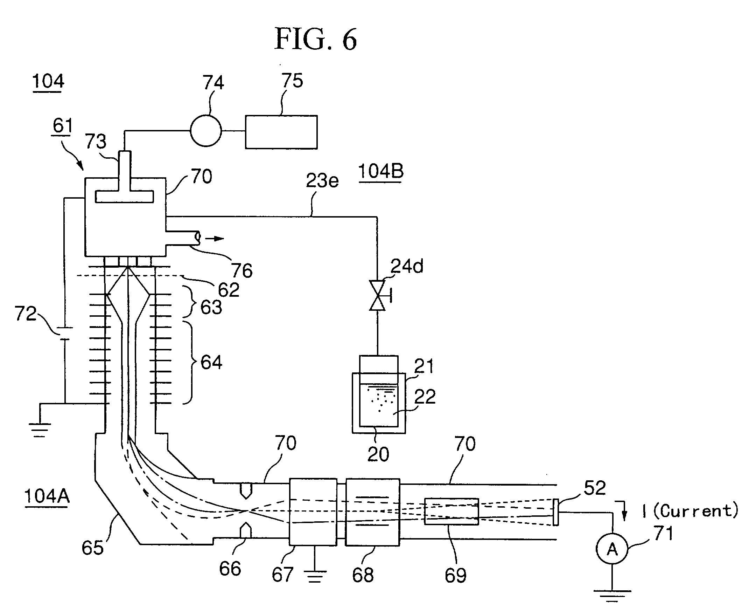

FIG. 6 is a side view showing a structure of an ion implantation system (an impurity processing apparatus) 104 according to a third embodiment of the present invention. As the detailed structure of a water containing gas supply part 204B in FIG. 5 is same as that in FIG. 2, the description is omitted.

In FIG. 6, the second embodiment has not only an ion injection part 104A having a apparatus structure necessary for a standard ion injection but also a water containing gas supply part 104B for supplying an water vapor, etc.

First, the ion injection part 104A has a apparatus structure necessary for a standard ion injection. That is, there are provided an ion source housing (an impurity containing gas supply part) 61 which is an ion source; an ion leading-out electrode 62; a lens 63; an acceleration electrode 64; a mass analyzer 65; a mass selector slit 66; an electrostatic quadrupole lens 67; a scan electrode 68; and a 7° deflector neutron trap 69, in accordance with a flow direction of ion beams (an impurity containing gas). These are partitioned from an external unit by a partition wall 70. A substrate 52 is set in a lowermost downstream to inject ions. The substrate 52 is connected to an ammeter 71 for measuring an ion current for monitoring a dose.

The ion source housing 61 is provided with an introduction port of an ion source (not shown) and further an exhaust port 76 connected to an exhausting apparatus for decompressing an interior of the ion source housing 61, and the interior of the ion source housing 61 is regulated at an appropriate pressure. Furthermore, the ion source housing 61 is provided with an ion source electrode (second plasma generating means) 73 which is an electrode on one side of the electrodes which ionize an ion source, and this ion source electrode 73 is connected to a power supply 75 and a matching box 74. A voltage is applied to between this ion source electrode 73 and the partition wall 70 to plasmanize the ion source. Furthermore, this ion source electrode 73 serves both as an electrode for generating an electric field accelerating ions relative to an acceleration electrode 64, and a power supply 72 for supplying a DC voltage is connected to a space between the ion source electrode 73 and the acceleration electrode 64.

The water containing gas supply part 104B has a generating apparatus which has the similar structure to that in FIG. 2 and generates a water vapor, etc., and a piping 23e is extended from this generating apparatus to the ion injection part 104A. The piping 23e is connected to the ion source housing 61 in an upmost upstream of positions necessary for cleaning in the ion injection part 104A, to constitute an introduction port of a water containing gas, etc. Namely, the introduction port of a water containing gas, etc. is connected to the plasma generating part for plasmanizing the ion source.

In response to the apparatus structure of such the water containing gas supply part 104B, the ion injection part 104A serves both as the apparatus structure necessary for a standard ion injection and a cleaning electrode (first plasma generating means) for plasmanizing the water containing gas, etc. by the ion source electrode 73. Namely, the ion source electrode 73 is provided at the same position as the introduction port of the water containing gas. A power of DC, AC, LF or RF can be applied to between this ion source electrode 73 and the partition wall 70. Incidentally, the introduction port of the water containing gas may be provided in an upstream of the ion source electrode 73.

When the ion injection part 104A is purified after the ion injection, the water containing gas is introduced into the ion source housing 61 and plasmanized, thereby to purify each position in the ion source housing 61 and the ion injection part 104A in the downstream.

As described above, the ion implantation system 104 according to the third embodiment comprises not only a structure necessary for a standard ion injection but also first plasma generating means 73, 74, 75 containing the cleaning electrode 73 for plasmanizing the water containing gas, which is provided with an introduction port of a water containing gas at positions necessary for cleaning in accordance with a flow direction of ion beams and in an upstream thereof, and is provided at positions which are same as those of the introduction port of the water containing gas and necessary for cleaning, or in an upstream thereof.

That is, as the ion implantation system 104 according to the third embodiment has the same structure as in the first embodiment, it has the same effects as in the first embodiment.

As described above, the present invention was in detail described according to the embodiments, and a scope of the present invention is not limited to embodied examples illustrated as the aforementioned embodiments, and a modification of the aforementioned embodiments within a scope not deviating from the gist of the present invention is contained in the scope of the present invention.

For example, in the first and second embodiments, the plasma processing apparatus is used as a apparatus for forming the amorphous boron film or the amorphous carbon film, but it is possible to also use it as the plasma doping apparatus by changing the impurity containing gas. In this case, as they have the plasma generating means of the water containing gas at positions where the doping gas is plasmanized, or at the same positions as the doping positions, or in the upstream thereof, the interior of the plasma generation chamber or the doping chamber is cleaned by plasma-processing the water containing gas after doping, and it is possible to remove products or residues containing boron, carbon, etc.

Furthermore, according to the first embodiment, the introduction port of the water containing gas is common to the introduction port of the impurity containing gas, but they may be separately provided. In this case, the introduction port of the water containing gas is provided at the same position as in the plasma generating means, and may be provided at positions where the water containing gas is plasmanized and also the plasma reaches effectively the substrate. Alternatively, the introduction port of the water containing gas may be provided in the upstream of the plasma generating means.

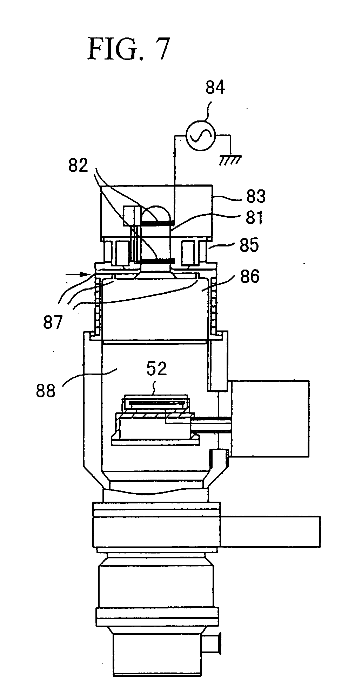

Though there is used means 12a, 12b, 16 for applying a voltage to between a pair of electrodes 12a, 12b of parallel plate type to generate plasma, means 35, 36, 37 for generating the plasma by means of an electron cyclotron resonance, or means for applying a voltage to between the partition wall 70 of the chamber and the electrode 73 to generate the plasma as the first plasma generating means 12a, 12b, 16, 35, 36, 37, 73 in the above embodiment, means for generating the helicon plasma by a radiation of an electromagnetic field from an antenna may be used as shown in FIG.7. The means for generating the helicon plasma comprises an antenna 82 around a plasma generating chamber 81, a radio frequency (13.56 MHz) power supply 84 connecting the antenna 82 through a matching box 83, and a magnet 85. In addition, the symbol 88 in FIG.7 indicates a processing chamber, the symbol 86 indicates a regulating chamber effecting a communication between the plasma generating chamber 81 and the processing chamber 88 and regulating a plasma distribution in the chamber 86, the symbol 87 indicates processing gas introduction ports introducing an impurity containing gas or a water containing gas.

As described above, according to the present invention, as the water containing gas supply part is connected to the process chamber of the impurity processing apparatus or the flow path of the impurity containing gas, and also there is provided the plasma generating means in the process chamber in a space between the introduction port of the water containing gas and the substrate, or the flow path of the impurity containing gas, after the impurity doping using the impurity containing gas of boron, etc. or the plasma process of a film formation, etc., it is possible to clean an interior of the process chamber, etc. by the plasma of the water containing gas.

The water containing gas is used as a cleaning gas instead of an element simple substance such as hydrogen, argon or the like, whereby it is possible to remove processing products or residues containing impurities with a short period of time without damaging the surface of the semiconductor substrate or the inner wall of the process chamber, etc.

## Claims

1. An impurity processing apparatus, comprising:
(a) an impurity containing gas supply part (102B, 103B, 61) for supplying an impurity containing gas;
(b) a water containing gas supply part (102C, 103C, 104B) for supplying a water containing gas; and
(c) a chamber (11, 31, 32, 70) comprising
(1) an introduction port of an impurity containing gas which is connected to the impurity containing gas supply part (102B, 103B, 61);
(2) a substrate holder (12b, 33) supporting a to-be-processed layer (52) which is ion-injected or doped using the impurity containing gas, or on which a film is formed;
(3) an introduction port of a water containing gas which is provided in an upstream of the substrate holder (12b, 33) in accordance with a flow direction of the impurity containing gas, and is connected to the water containing gas supply part (102C, 103C, 104B), and
(4) first plasma generating means (12a, 12b, 16, 35, 36, 37, 73) which are provided in a space from the introduction port of the water containing gas to the substrate holder (12b, 33) in accordance with a flow direction of the impurity containing gas, and plasmanized the water containing gas.

2. An impurity processing apparatus according to claim 1, further comprising:
second plasma generating means (12a, 12b, 16, 35, 36, 37, 73) for plasmanizing the impurity containing gas.

3. An impurity processing apparatus according to claim 2, wherein
the first plasma generating means (12a, 12b, 16, 35, 36, 37, 73) is same as the second plasma generating means.

4. An impurity processing apparatus according to claim 1, wherein
the first plasma generating means (12a, 12b, 16, 35, 36, 37, 73) is means for applying a voltage to between a pair of electrodes (12a, 12b) of parallel plate type to generate plasma, means for generating the plasma by means (35, 36, 37) of an electron cyclotron resonance, means for generating the helicon plasma by a radiation of an electromagnetic field from an antenna, or means for applying a voltage to between the partition wall (70) of the chamber and the electrode (73) to generate the plasma.

5. An impurity processing apparatus according to claim 1, wherein
the impurity containing gas is a gas including at least one selected from the group consisting of phosphorus, boron, antimony, arsenic, gallium, aluminum, germanium and carbon.

6. An impurity processing apparatus according to claim 1, wherein
the water containing gas is water vapor or a gas in which hydrogen or argon is added to the water vapor.

7. A method for cleaning an impurity processing apparatus, comprising the steps of:
mounting a to-be-processed layer (52) in a chamber (11, 31, 32, 70);
introducing an impurity containing gas into the chamber (11, 31, 32, 70) to plasmanize it;
injecting ions into the to-be-processed layer (52), or doping it, or forming a film on the to-be-processed layer (52) by use of the plasma;
introducing the water containing gas into the chamber (11, 31, 32, 70) after injecting ions into the to-be-processed layer (52), or doping it, or forming a film on the to-be-processed layer (52);
plasmanizing the water containing gas in the chamber (11, 31, 32, 70); and
contacting the plasma of the water containing gas to remove products or residues containing the impurity in the chamber (11, 31, 32, 70).

8. A method for cleaning an impurity processing apparatus according to claim 7, wherein
the impurity containing gas is a gas including at least one selected from the group consisting of phosphorus, boron, antimony, arsenic, gallium, aluminum, germanium and carbon.

9. A method for cleaning an impurity processing apparatus according to claim 7, wherein
the water containing gas is water vapor or a gas in which hydrogen or argon is added to the water vapor.
